# FASCICULE DE BREVET EUROPEEN

(11) **EP 2 550 679 B1**
(45) Date de publication et mention de la délivrance du brevet: **18.03.2015**
(21) Numéro de dépôt: 11715978.0
(22) Date de dépôt: 23.03.2011
(51) Int. Cl.: H01L 31/0216, H01L 31/048, C03C 17/00, C08F 292/00, C08L 51/10, C09D 7/12, G02B 1/11, C23C 18/12, H01L 31/042

(54) **Dispositifs photovoltaïques comportant une couche anti-reflet à base d'objets dispersés présentant des domaines d'indices de réfraction distincts**
PV-Module mit Antireflexionsschicht mit dispergierten Objekten mit Bereichen mit unterschiedlichem Brechungsindex
Photovoltaic devices comprising an anti-reflective layer containing dispersed objects having areas with different refractive indices

(30) Priorité: 23.03.2010 FR 1052069
(43) Date de publication de la demande: 30.01.2013
(73) Titulaire: Polyrise, 33600 Pessac (FR)
(72) Inventeur: GAUD, Vincent, F-33400 Talence (FR); LOUARN, Mélanie, 33600 Pessac (FR); ROUGE, Fabien, F-33000 Bordeaux (FR)
(74) Mandataire: Blot, Philippe Robert Emile
(86) Numéro de dépôt international: PCT/FR2011/050615
(87) Numéro de publication internationale: WO 2011/117538

(56) Documents cités:
- EP-A1- 2 128 090
- EP-A1- 2 161 759
- WO-A1-2009/023353
- WO-A2-2008/140282
- US-A- 6 130 379
- US-A1- 2004 253 443
- US-A1- 2007 190 305
- US-A1- 2009 071 532

## Description

La présente invention a trait à des dispositifs photovoltaïques, de type cellules et modules photovoltaïques, qui présentent une efficacité élevée de par la présence d'une ou plusieurs couches ayant des propriétés anti-reflet permettant d'améliorer la transmission lumineuse.

Par *"couche à propriétés anti-reflet",* on entend ici une couche qui, déposée sur un substrat solide, permet de diminuer les propriétés de réflexion d'au moins certaines ondes électromagnétiques dans le domaine allant des ultraviolets à l'infrarouge (ayant typiquement une longueur d'onde comprise entre 250 nm et 1500 nm) sur la surface modifiée du substrat solide, en augmentant la transmission de ces ondes.

L'obtention de propriétés anti-reflet est tout particulièrement recherchée dans le domaine de la conversion photovoltaïque, où la diminution de la réflexion se traduit par une augmentation de la quantité de lumière incidente convertie et donc à une augmentation du rendement de conversion.

Pour éviter les phénomènes de réflexion dans le cadre de la conversion photovoltaïque, différentes solutions ont été proposées, qui ne s'avèrent pas pleinement satisfaisantes.

En particulier, il a été décrit des cellules photovoltaïques de première génération qui comprennent un matériau semi-conducteur, généralement une tranche (*wafer*) de silice, monocristallin ou polycristallin, dopé ou non, recouvert par une couche qui permet, entre autres, de procurer un effet anti-reflet et donc d'augmenter la quantité de lumière incidente reçue par le semi-conducteur.

Cette couche est typiquement constituée de nitrure de silicium, qui peut notamment être déposée en phase vapeur par un dépôt plasma par exemple selon la technique dite PECVD (pour l'anglais *"Plasma enhanced chemical vapor deposition*"). Le nitrure de silicium, originellement proposé pour passiver la surface du silicium en remplacement des couches d'oxydes de titane ou de sulfure de zinc qui étaient historiquement utilisées à cet effet, s'avère présenter en outre des propriétés anti-reflet. Alternativement, il a été proposé, plus récemment, des revêtements anti-reflet à base de dérivés de SiC. Pour plus de détails à ce sujet, on pourra notamment se reporter à Progress in Photovoltaics : Research and Applications. Prog. Photovolt. : Res. App. 7, 245-260 (1999).

L'effet anti-reflet apporté par un dépôt à base de nitrure de silicium du type précité est cependant relativement limité. En particulier, il s'agit d'un effet anti-reflet centré sur une longueur d'onde donnée uniquement. En effet, l'effet anti-reflet obtenu est surtout sensible pour une longueur d'onde λ₀ donnée, définie par la formule λ₀ = 4n.e, où n est l'indice de réfraction de la couche antireflet et e son épaisseur (n étant de préférence égal à (n₁.n₂)^{1/2} où n₁ et n₂ désignent les indices de réfraction des milieux de part et d'autre de la couche antireflet).

Pour obtenir un effet anti-reflet sur une gamme plus large de longueurs d'ondes, il a été proposé l'emploi de traitements anti-reflet bicouche ou multicouches, du type par exemple de la bicouche MgF2/ZnS déposée sur silicium décrite dans Res. Energ. Ren. : Valorisation) 43-46 (1999). Ces dépôts multicouche s'avèrent cependant onéreux, et ce d'autant plus que le nombre de couches déposées est élevé, et les matériaux employés pour réaliser les multicouches sont en général peu efficaces en termes de passivation du semi-conducteur (par "passivation" on entend ici la faculté d'inhiber la recombinaison des paires électron/trou créées par effet photovoltaïque)..

Les dépôts antireflet du type précités effectués sur des semi conducteurs sont généralement employés non pas sur des cellules photovoltaïques isolées, mais sur des modules photovoltaïques. Le terme de "module photovoltaïque" (ou plus simplement "module"), au sens où il est employé dans la présente description, désigne un dispositif photovoltaïque comprenant plusieurs cellules photovoltaïques en connexion électrique les unes avec les autres et recouvertes par un polymère (par exemple noyées au sein d'une matrice polymère), le polymère de couverture étant typiquement une matrice d'EVA. Dans des modules de ce type, les propriétés de réflexion des cellules photovoltaïques sont modifiées par rapport à leurs propriétés à l'état isolé, notamment compte tenu de leur mise en contact avec la matrice polymère, qui a un indice de réfraction très différent de celui de l'air avec lequel est mis en contact la cellule lorsqu'elle est à l'état isolée.

Un but de la présente invention est de fournir des moyens permettant d'améliorer la conversion de dispositifs photovoltaïques en s'affranchissant le plus possible des inconvénients rencontrés avec les solutions préconisées actuellement pour assurer un effet antireflet, et qui soient au moins aussi efficaces, et de préférence plus performants, que les solutions proposées à l'heure actuelle, et permettant en particulier d'accéder à des dispositifs photovoltaïques ayant une bonne efficacité de conversion photovoltaïque, sur une gamme étendue de longueurs d'onde.

A cet effet, la présente invention propose de mettre en oeuvre dans les dispositifs photovoltaïques une couche anti-reflet très spécifique, à base d'objets dispersés présentant des domaines d'indices de réfraction distincts, qui peut être déposée aisément et en une seule étape, contrairement aux dépôts multicouches actuellement préconisés.

L'invention a donc pour objet un dispositif photovoltaïque qui comprend :
- un matériau semi-conducteur (qui peut éventuellement être une association de matériaux semi-conducteurs) propre à assurer un effet photovoltaïque lorsqu'il est soumis à un rayonnement électromagnétique ;
- une couche anti-reflet, transparente vis-à-vis dudit rayonnement électromagnétique assurant l'effet photovoltaïque, cette couche antireflet contenant, à l'état dispersé, des objets de dimensions inférieures à 5 microns, de préférence inférieures à 2 microns, lesdits objets comprenant au moins deux zones constituées de deux substrats différents, transparents vis-à-vis dudit rayonnement électromagnétique et ayant des indices de réfraction distincts, à savoir :
   - un coeur ayant un premier indice de réfraction n_{C} ; et
   - une couche entourant le coeur, dite écorce, ayant un deuxième indice de réfraction n_{E}, distinct de l'indice de réfraction n_{C} du coeur, le rapport des dimensions du coeur aux dimensions de l'ensemble coeur/écorce étant compris entre 1 :1,5 et 1 :5.

On comprend que cette couche antireflet particulière à l'invention est placée sur le chemin du rayonnement électromagnétique, c'est-à-dire entre le milieu extérieur et le matériau semi-conducteur.

L'invention a aussi de manière générale pour objet l'utilisation d'un matériau transparent vis-à-vis du rayonnement électromagnétique, contenant, à l'état dispersé, des objets de dimensions inférieures à 5 microns, de préférence inférieures à 2 microns, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n_{C}; et
- une couche entourant le coeur, dite écorce, ayant un deuxième indice de réfraction n_{E}, distinct de l'indice de réfraction n_{C} du coeur, le rapport des dimensions du coeur aux dimensions de l'ensemble coeur/écorce étant compris entre 1 :1,5 et 1 :5,
pour former une couche antireflet pour un dispositif photovoltaïques, cette couche étant transparente vis-à-vis du rayonnement électromagnétique assurant l'effet photovoltaïque.

Dans un mode de réalisation, la présente invention a pour objet des dispositifs photovoltaïques qui comprennent :
- un matériau semi-conducteur (qui peut éventuellement être une association de matériaux semi-conducteurs) propre à assurer un effet photovoltaïque ;
- une couche protectrice dudit matériau semi-conducteur (typiquement une feuille de verre ou une feuille polymère, par exemple à base de PET ou de ETFE, cette couche protectrice pouvant notamment être déposée sur une sous-couche polymère, telle qu'une matrice d'EVA) ; et
- entre le matériau semi conducteur et la couche protectrice (généralement entre le matériau semi-conducteur et la sous-couche de polymère de type EVA, lorsqu'une telle sous couche est présente), une couche interne anti-reflet, transparente vis-à-vis dudit rayonnement électromagnétique assurant l'effet photovoltaïque, cette couche interne antireflet contenant, à l'état dispersé, des objets de dimensions inférieures à 5 microns, de préférence inférieures à 2 microns, plus préférentiellement encore inférieurs à 1 micron, voire inférieures à 500 nm, lesdits objets comprenant au moins deux zones constituées de deux substrats différents, transparents vis-à-vis dudit rayonnement électromagnétique et ayant des indices de réfraction distincts, à savoir :
   - un coeur ayant un premier indice de réfraction n_{C}; et
   - une couche entourant le coeur (désignée ci-après par « écorce »), ayant un deuxième indice de réfraction n_{E,} distinct de l'indice de réfraction n_{C} du coeur, où le rapport des dimensions du coeur aux dimensions de l'ensemble coeur/écorce est compris entre 1 :1,5 et 1 :5.

Ces dispositifs photovoltaïques selon l'invention présentent une structure stratifiée spécifique qui comporte typiquement une structure multicouche déposée sur le matériau semi-conducteur (lequel peut d'ailleurs se présenter sur la forme d'une ou plusieurs couches semi-conductrice), cette structure multicouche déposée sur le matériau semi-conducteur comportant typiquement, dans cet ordre, du matériau semi conducteur vers l'extérieur :
- éventuellement une ou plusieurs couches destinées à fournir un effet anti-reflet, par exemple une couche de SiN du type précité,
- au moins une couche interne anti-reflet selon l'invention (éventuellement une succession de plusieurs couches de ce type, par exemple 2 ou 3) contenant, à l'état dispersé, les objets de dimensions inférieures à 5 microns à structure coeur/écorce à base de substrats ayant des d'indices de réfraction distincts;
- éventuellement (et le plus souvent) une couche polymère (par exemple une matrice de type EVA servant à lier entre elles plusieurs cellules photoélectrique comportant une couche anti-reflet selon l'invention sous la forme d'un module photovoltaïque ;
- au moins une couche protectrice (typiquement une plaque de verre ou une feuille de matière plastique).

Plus généralement, la couche interne anti-reflet qui est présente dans les dispositifs selon l'invention peut être soit en contact direct avec le matériau semi-conducteur, soit être déposé sur une ou plusieurs autre(s) couche(s) déposées intermédiairement sur le matériau semi-conducteur.

Ainsi, selon un mode de réalisation particulier, le matériau semi-conducteur est du silicium, dopé ou non dopé, sur lequel est déposé une couche de nitrure de silicium, puis la couche interne anti-reflet selon l'invention, cet ensemble semi-conducteur/SiN/couche interne anti-reflet étant lui-même recouvert par la couche protectrice, typiquement un plaque de verre (avec généralement une couche polymère de type EVA entre la couche interne anti-reflet et la couche protectrice).

La couche anti-reflet employée dans le cadre de la présente invention présente l'avantage de pouvoir être employée dans les dispositifs photovoltaïques actuels sans avoir à modifier leur mode de synthèse (le dépôt de la couche interne antireflet s'intercalant simplement entre les dépôts de couche usuels dans la synthèse de systèmes photovoltaïques), et avec un surcoût acceptable, en ce sens que les coûts liés à l'intégration de la couche antireflet additionnelle sont largement compensés par l'amélioration de l'efficacité du dispositif, ce qui se traduit globalement par une diminution des coûts de production de l'énergie électrique. Les couches anti-reflet selon l'invention peuvent notamment être utilisées dans des dispositifs photovoltaïques de première génération, comme illustré dans l'exemple donné à la fin de la présente description. Alternativement, elles peuvent être employées dans des dispositifs de générations ultérieures (dispositifs de 2^{ème} et 3^{ème} générations notamment).

La couche interne anti-reflet utilisée selon l'invention peut, selon un mode de réalisation possible, être mise en oeuvre en compléments d'autres couches anti-reflet présentes dans le dispositif (couche de SiN par exemple) ou bien, selon un mode de réalisation alternatif, à titre d'unique couche anti-reflet, à l'exclusion de couches antireflet ne comprenant pas d'objets de dimensions inférieures à 5 microns à structure coeur/écorce à base de substrats ayant des d'indices de réfraction distincts.

La couche interne anti-reflet déposée selon l'invention est typiquement déposée sur un semi-conducteur sur lequel des pistes électriques (contacts) ont été préalablement déposées par sérigraphie. De préférence, avant le dépôt de la couche anti-reflet de l'invention, ces pistes électriques sont protégées, de façon réversible. Cette protection réversible peut typiquement être réalisée en déposant un adhésif pelable sur les pistes électriques, au moins au niveau des contacts électriques du dispositif, cet adhésif pelable pouvant ensuite être aisément retiré après dépôt de la couche anti-reflet, pour rendre à nouveau accessibles les contacts électriques.

Selon un mode de réalisation spécifique la couche protectrice présente dans les dispositifs selon l'invention peut en outre être elle-même pourvue d'un revêtement antireflet (en particulier lorsqu'il s'agite d'une feuille de verre ou de polymère), ce qui améliore encore la conversion photovoltaïque du dispositif, en augmentant la quantité de lumière incidente fournie au matériau semi-conducteur. Selon ce mode de réalisation spécifique, le revêtement anti-reflet déposé sur la couche protectrice peut, avantageusement, être de même nature que la couche interne anti-reflet, à savoir qu'il s'agit avantageusement d'un revêtement transparent (mono ou multicouche), contenant, à l'état dispersé, des objets des objets de dimensions inférieures à 5 microns, de préférence inférieures à 2 microns, plus préférentiellement encore inférieurs à 1 micron, voire inférieurs à 500 nm, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n'_{C;et}
- une couche entourant le coeur (désignée ci-après par « écorce »), ayant un deuxième indice de réfraction n'_{E,} distinct de l'indice de réfraction n'_{C} du coeur, où le rapport des dimensions du coeur aux dimensions de l'ensemble coeur/écorce est compris entre 1 :1,5 et 1 :5.

L'invention trouve aussi à s'appliquer aux dispositifs photovoltaïques comprenant ou constitués d'un système solaire à concentration équipé d'une lentille. Une couche antireflet selon l'invention peut y être appliquée conformément au mode de réalisation qui vient d'être décrit, c'est-à-dire comme couche interne antireflet. Il est aussi possible dans un mode de réalisation particulier, d'appliquer une couche antireflet de cette nature sur une face ou sur les deux faces de la lentille, en contact direct ou indirect avec la surface correspondante de la lentille. Il est également possible de combiner une couche interne antireflet et une ou deux couches antireflet appliquée(s) sur l'une ou les deux faces de la lentille. Pour faciliter l'exposé qui suit, on emploiera indifféremment, sauf contre-indication évidente, pour tous les modes de réalisation de l'invention, la dénomination « couche interne antireflet ».

La couche interne anti-reflet déposée sur le matériau semi-conducteur selon la présente invention, et les objets qu'elle contient, sont transparents au moins vis-à-vis des ondes électromagnétiques permettant l'effet photovoltaïque dans le dispositif. Ils sont typiquement visuellement transparents (à savoir transparents pour tout ou partie de la lumière visible). Alternativement, ils peuvent n'être qu'optiquement transparents, à savoir transparents uniquement pour certains rayonnements non visibles.

Au sens de la présente description, un revêtement, un objet, un matériau ou un substrat est dit *"transparent",* pour un rayonnement électromagnétique de longueur d'onde À donnée, lorsqu'il se laisse traverser par un flux dudit rayonnement électromagnétique, de préférence sans absorber ce flux ou en n'absorbant qu'une partie minoritaire de ce flux. Un matériau ou un substrat dit transparent à une longueur d'onde λ a de préférence un coefficient d'absorption molaire le plus faible possible à cette longueur d'onde, ce coefficient d'absorption molaire (dit aussi coefficient "d'extinction" molaire) étant de manière préférée inférieur ou égal à 200 L.mol⁻¹.cm⁻¹, et plus préférentiellement inférieur ou égal à 100 L.mol⁻¹.cm⁻¹, à la longueur d'onde considérée.

Le coeur et l'écorce des objets qui sont présents à l'état dispersé dans la couche interne anti-reflet des dispositifs selon la présente invention (et éventuellement dans le revêtement déposé sur la couche de protection) sont constitués de substrats qui sont transparents notamment vis-à-vis du rayonnement électromagnétique pour lequel l'effet anti-reflet est recherché. Les indices de réfraction des substrats constitutifs du coeur et de l'écorce de ces objets dispersés auxquels il est fait référence dans la présente description, à savoir respectivement le premier indice de réfraction n_{C} du coeur et le deuxième indice de réfraction n_{E} de la couche entourant le coeur, désignent les indices de réfraction des substrats à la longueur d'onde (ou aux longueurs d'ondes) du rayonnement électromagnétique pour lequel le traitement anti-reflet est recherché.

La couche interne anti-reflet des dispositifs selon la présente invention est en général une monocouche, issue du dépôt d'une seule et unique couche. Typiquement, cette couche interne anti-reflet a une épaisseur comprise entre 10 nm et 1 micron, plus préférentiellement entre 50 nm et 500 nm. De manière générale, la couche interne est mise en oeuvre dans des conditions assurant sa fonction antireflet, étant entendu que cette fonction peut être assurée par cette seule couche ou par une combinaison de couches, l'incluant.

Il est souvent préférable (notamment pour limiter tout phénomène d'absorption parasite) que la couche interne anti-reflet des dispositifs selon la présente invention ait une épaisseur inférieure à 1 micromètre, de préférence inférieures à 800 nm, et plus préférentiellement encore inférieure à 500 nm, cette épaisseur étant avantageusement entre 10 et 600 nm, notamment entre 50 et 500 nm ; par exemple entre 100 et 400 nm. Il est à noter à ce sujet qu'il est préférable que la taille des objets présents dans le revêtement déposé selon l'invention soit d'autant plus élevée que la longueur d'onde du rayonnement pour lequel on cherche à obtenir l'effet anti-reflet est grande (typiquement, pour un rayonnement électromagnétique de longueur d'onde λ donnée il est préférable que le coeur des objets ait des dimensions supérieures à λ/4 et que l'épaisseur déposée sur le coeur soit également supérieure à λ/4).

Les objets qui sont dispersés au sein de la couche interne anti-reflet des dispositifs selon la présente invention sont des objets isotropes ou anisotropes ayant, de préférence, des dimensions inférieures à 2 microns, ces dimensions étant typiquement comprises entre 2 nm et 1 microns. Notamment de façon à ce qu'ils présentent des zones de coeur et d'écorce d'indices de réfraction clairement distincts, ces objets dispersés ont de préférence des dimensions égales à au moins 3 nm, et plus préférentiellement d'au moins 5 nm (ces dimensions étant avantageusement supérieures ou égale à 10 nm ; voire à 20 nm, par exemple d'au moins 50 nm). Typiquement, les objets qui sont dispersés au sein de la couche interne anti-reflet des dispositifs de la présente invention ont des dimensions comprises entre 10 nm et 800 nm, par exemple entre 20 et 600 nm. Ces dimensions sont à choisir d'autant plus faibles que l'épaisseur recherchée pour le revêtement transparent est faible (l'épaisseur du revêtement transparent est en général au moins égale à la dimension des objets dispersés qu'elle contient). Ainsi, il pourra typiquement s'avérer intéressant que la couche interne anti-reflet comprenne des objets dispersés ayant des dimensions inférieures à 400 nm, par exemple inférieures à 300 nm, plus préférentiellement inférieures ou égales à 200 nm, voire inférieures ou égales à 100 nm, par exemple inférieures ou égales à 50 nm.

Les objets qui sont dispersés au sein de la couche interne anti-reflet des dispositifs de la présente invention sont généralement constitués par un coeur du type précité ayant le premier indice de réfraction n_{C} entouré par l'écorce ayant le deuxième indice de réfraction n_{E}.

Alternativement, toutefois, les objets dispersés peuvent comprendre au moins une couche d'enrobage additionnelle autour de cet ensemble coeur-écorce. Le cas échéant, chacune des couche d'enrobage additionnelle est constituée par un matériau transparent vis-à-vis du rayonnement électromagnétique pour lequel l'effet anti-reflet est recherché et, de préférence, chacune des couche d'enrobage additionnelle a un indice de réfraction différent de la ou des couche(s) avec laquelle elle est en contact.

Dans les objets présents à l'état dispersé au sein du de la couche interne anti-reflet des dispositifs de la présente invention, l'écorce qui entoure le coeur est constituée par un substrat de nature organique et/ou inorganique, de même que la (ou les) éventuelle(s) couche(s) d'enrobage. Le plus souvent, le coeur des objets présents à l'état dispersé au sein de la couche interne est, lui aussi, constitué par un substrat inorganique et/ou organique. Selon un autre mode de réalisation, plus particulier, le coeur peut être vide (selon ce mode spécifique, les objets dispersés sont de type particules creuses et l'indice de réfraction n_{C} du coeur est alors sensiblement égal à 1).

Dans les objets qui sont dispersés au sein de la couche interne anti-reflet des dispositifs de la présente invention, l'épaisseur moyenne de l'écorce entourant le coeur a des dimensions du même ordre de grandeur que celles du coeur et avec un rapport des dimensions du coeur aux dimensions de l'ensemble coeur/écorce constitué par le coeur ayant le premier indice de réfraction n_{C} entouré par l'écorce ayant le deuxième indice de réfraction n_{E} compris entre 1 : 1,5 et 1 : 5, ce rapport étant avantageusement de l'ordre de 1 : 2,5. Au sens de la présente description, l'expression « rapport des dimensions du coeur aux dimensions de l'ensemble coeur/écorce ». on désigne le rapport de la dimension caractéristique du coeur à la dimension caractéristique de l'ensemble coeur/écorce dans le cas de particules de type isotrope, ou bien le rapport des dimensions caractéristiques du coeur et des dimensions caractéristique de l'ensemble coeur/écorce dans le cadre de particules anisotropes. Ainsi, dans le cadre de particules isotropes, ce rapport peut être défini comme le rapport du diamètre moyen du coeur rapporté au diamètre moyen de l'ensemble coeur/écorce.

Typiquement, un objet dispersé présent dans la couche interne anti-reflet des dispositifs de la présente invention peut par exemple se présenter sous la forme d'un coeur de morphologie isotrope (sensiblement sphérique par exemple) et formant, avec la couche ayant le deuxième indice de réfraction n_{E} qui l'entoure, un ensemble coeur/écorce de morphologie isotrope (sensiblement sphérique par exemple) ayant une dimension moyenne d_{C+E} comprise entre 2 nm et 1 micron, par exemple entre 5 nm et 800 nm, notamment entre 10 nm et 500 nm, avec un rapport d_{C}/d_{C+E} avantageusement compris entre 1 :1,5 et 1 : 5, par exemple entre 1 :1,8 et 1 : 4, et typiquement de l'ordre de 1 : 2,5.

Les dimensions d'objets à l'état dispersé auxquelles il est fait référence dans la présente description se réfèrent à des dimensions telles qu'elles sont mesurées par diffusion de la lumière, notamment par diffusion dynamique de la lumière, par exemple à l'aide d'un équipement de type Malvern (Zetasizer). Typiquement, les dimensions mesurées par diffusion de la lumière sont déterminées sur des objets à l'état dispersé. Pour ce faire, si besoin est, on peut disperser les objets dont on cherche à déterminer les dimension dans un solvant approprié (l'eau, l'éthanol, un mélange eau/éthanol, le tétrahydrofurane, ou le diméthylsulfoxide, par exemple), à une concentration allant typiquement de 0,1mg/ml à 20 mg/ml. L'échantillon à analyser, qui contient les objets à l'état dispersé, est placé dans le faisceau incident d'un laser et on mesure la diffusion à un angle de 90°. Les dimensions mesurées selon cette méthode de diffusion de la lumière ont une résolution élevée (typiquement la mesure est effectuée avec une précision à+/-0,4 nm près).

Ces mesures effectuées en diffusion de la lumière sont corroborées par des méthodes de mesure employant la microscopie électronique, qui permet en outre d'accéder aux dimensions des parties constitutives (coeur et écorce notamment) des objets dont la dimension plus globale est déterminée par diffusion de la lumière. Des méthode d'analyse particulièrement adaptées pour accéder aux dimensions des objets à l'état dispersé et de leur parties constitutives sont les techniques de microscopie électronique de type SEM (microscopie électronique à balayage) et TEM (microscopie électronique à transmission), dont les principes sont notamment décrits dans ASTM standards, Digital library, chapitre 72, JG Sheehan (1995).

Dans le cadre de la présente invention, les inventeurs ont mis en évidence que, de façon inattendue, une couche interne comprenant des objets microniques ou submicroniques du type précité, à savoir ayant un coeur et une couche d'enrobage ayant des indices de réfraction n_{C} et n_{E}, on obtient, par le dépôt de cette seule couche, confère un effet anti-reflet efficace au sein des dispositifs photovoltaïques où cette couche est introduite.

Cet effet antireflet peut être observé à la fois pour des cellules photovoltaïques isolées et pour des modules photovoltaïque sous forme d'un module photovoltaïque comprenant plusieurs cellules photovoltaïques en connexion électrique les unes avec les autres et noyées au sein d'une matrice polymère ou recouvertes par un polymère. Il est des compétences de l'homme du métier d'adapter la nature exacte du revêtement anti-reflet à employer selon le cas.

Sans vouloir être lié par une théorie particulière, à la lumière des travaux effectués par les inventeurs dans le cadre de l'invention, il semble pouvoir être avancé que cet effet anti-reflet s'explique, au moins en partie, par le fait que chacun des objets dispersés se comporterait comme une sorte de *"nano-domaine"* ayant, à son niveau local, une structure de type multicouche qui le rendrait propre à assurer localement un effet similaire à celui observé avec les dépôts multicouches usuels (plus macroscopiques), l'addition de ces effets locaux conférant au matériau des propriétés anti-reflet globales particulièrement intéressantes.

Il ressort des expériences réalisées par les inventeurs que la dispersion des objets ayant cette "*structure multicouche locale*" au sein du revêtement déposé assurent un effet anti-reflet similaire, sinon amélioré, par rapport à l'effet observé avec des dépôts multicouches. En général, il est préférable que les couches anti-reflet déposées selon l'invention ne soient pas soumises à des traitements thermiques susceptibles d'affecter cette structure spécifique et en particulier la structure multicouche locale précitée. A cet effet, il est préférable que la ou les couches internes anti-reflet déposées selon l'invention ne soient pas soumises à des températures dépassant 250°C, et, de préférence, on préfère maintenir leur température à des valeurs ne dépassant pas 200°C, de préférence ne dépassant pas 180°C.

Dans certains rares cas, un traitement thermique d'une couche antireflet selon l'invention peut être envisagée sans affecter le maintien d'une structure de type "*structure multicouche locale*" du type précité. Dans ce cas, il peut notamment être envisagé d'effectuer le dépôt de pistes électriques (contacts) sur la surface de la couche anti-reflet plutôt que préalablement au dépôt de cette couche.

Dans les autres cas, le traitement thermique d'une couche anti-reflet selon l'invention, généralement à prohiber, conduit, s'il est mis en oeuvre, à l'obtention de couches nanostructurées ou nanoporeuses qui, bien que de structure différente de celle de la couche anti-reflet initiale, peuvent présenter des propriétés intéressantes, notamment des propriétés anti-reflet. Dans ce cadre, les couches anti-reflet selon l'invention peuvent être employées à titre de couches précurseur de couches nanostructurées ou nanoporeuses. Cette conversion peut par exemple être observée lorsqu'on dépose par sérigraphie une piste métallique sur une couche anti-reflet selon l'invention, ce qui implique généralement un traitement thermique à une température d'au moins 600°C.

Il s'avère en outre que les couches anti-reflet préparées selon l'invention présentent en outre des qualités de transparence au moins similaires à celles des dépôts multicouches connus de l'état de la technique. Dans de nombreux cas, cette transparence est même supérieure (en effet, dans la mesure où ils ne nécessitent qu'un unique dépôt sous forme de monocouche, les dépôts anti-reflet selon l'invention sont susceptibles de se révéler plus transparents que des revêtement multicouche plus épais où les phénomène d'absorption des rayonnements ont plus de chance de se produire). Ces qualités de transparence, obtenues sans avoir à mettre en oeuvre de technique compliquée, font des dépôts anti-reflet de l'invention une solution alternative de choix aux revêtements multicouche, qui permettent d'accéder simplement, à des matériaux transparents ayant une transmission élevée d'ondes électromagnétiques allant de l'UV à l'infrarouge.

Par ailleurs, dans la mesure où elle ne nécessite que le dépôt d'une couche unique pour obtenir l'effet d'amélioration recherché, les moyens de fourniture de l'effet anti-reflet mis en oeuvre dans le cadre de la présente invention se révèlent moins onéreux et moins longs à mettre en oeuvre que les méthodes par dépôts multicouche, ce qui constitue encore un autre des avantages de la présente invention.

Bien qu'une monocouche soit suffisante à titre de couche interne anti-reflet dans les dispositifs de la présente invention pour obtenir l'effet anti-reflet recherché, il est possible, selon un mode de réalisation particulier, de déposer plusieurs couches interne anti-reflet successives (par exemple au moins 2, voire au moins 3) entre le matériau semi conducteur et la couche protectrice, où ces couches antireflet contiennent, à l'état dispersé, des objets ayant la structure coeur-écorce précitée. Les dépôts multicouches de ce type peuvent notamment être employés pour conférer des propriétés anti-reflet particulièrement prononcées.

L'effet antireflet conféré par la couche anti-reflet se révèle généralement d'autant plus prononcé que les indices de réfraction n_{C} et n_{E} du coeur et de la couche d'enrobage (écorce) qui l'entoure sont différents. Dans ce cadre, il se révèle généralement avantageux que, à la longueur d'onde (et le plus souvent aux longueurs d'ondes) du rayonnement électromagnétique pour lequel l'effet anti-reflet est recherché, la différence (n_{C} - n_{E}) entre les indices de réfraction du coeur et de la couche d'enrobage qui l'entoure soit, en valeur absolue, supérieure à 0,01, cette différence étant plus avantageusement d'au moins 0,1, et plus avantageusement encore d'au moins 0,2. Des différences de 0,3 ou plus conduisent le plus souvent à des résultats encore davantage intéressants.

La couche interne transparente qui joue le rôle de véhicule des objets dispersés dans les dispositifs selon la présente invention peut être tout type de couche déposable avec une épaisseur inférieure à 10 microns, plus préférentiellement inférieure à 5 microns et plus avantageusement encore inférieure à 1 micron, voire inférieure à 500 nm, par exemple entre 10 et 400 nm, notamment entre 20 et 200 nm. Il peut s'agir par exemple d'un vernis ou d'une couche polymère.

Selon un mode de réalisation particulièrement intéressant, la couche interne anti-reflet présente dans les dispositifs de la présente invention est un revêtement sol/gel. Les revêtements sol/gel sont des revêtements de type bien connus, qui sont obtenus en hydrolysant des alcoxydes minéraux tels que des alcoxydes de silicium, de titane, de zirconium ou de zinc, ce qui conduit à une réaction similaire à une polymérisation des espèces minérales, conduisant dans un premier temps à la formation d'un sol de particules d'oxyde minéral (silice, TiO₂ ou ZrO₂ par exemple), puis à une gélification progressive du milieu, conduisant *in fine* à l'obtention d'une réticulation de l'ensemble des espèces minérales sous la forme d'une structure rigide analogue à un verre. Les dépôt dits « sol/gel » sont des dépôts effectués en déposant sur un substrat une couche d'un milieu réactionnel de ce type, à l'état de sol non gélifié ou partiellement gélifié, puis en laissant la gélification se poursuivre jusqu'à obtenir un durcissement de la couche. Le dépôt peut être effectué par toute méthode conventionnelle adaptée, notamment par la technique dite de trempage ("*dip-coating*" en anglais) ou de dépôt centrifuge (*"spin-coating"* en anglais) qui sont des techniques bien connues, notamment de Process Engineering Analysis in Semiconductor Device Fabrication, S. Middlemann & A. Hochberg, Mcgraw-Hill College, p.313 (1993), ou bien de la demande EP 1 712 296. D'autres techniques de dépôt adaptées incluent en particulier les méthodes de pulvérisation (dites par "*spray*"), notamment les dépôts par pulvérisation au moyen de buses soumises à des vibrations ultrasoniques (dites par "*spray ultrasonique*")*,* du type des équipements commercialisés par la société Sono-Tek.

La réalisation de la couche interne anti-reflet selon l'invention au moyen de la technique sol/gel précitée comporte avantageusement une étape de traitement thermique (séchage) à l'issue de la gélification, ce qui permet d'optimiser le durcissement de la couche sol/gel déposée, et, partant, de conférer une bonne cohésion au revêtement obtenu *in fine.* Ce traitement thermique peut aussi bien être réalisé à l'aide d'air chaud que par radiation infrarouge. Ce traitement est de préférence effectué en plaçant le semi-conducteur muni du revêtement anti-reflet en formation dans une étuve à une température comprise entre 20 et 200°C, plus préférentiellement entre 50 et 150°C. Selon un mode de réalisation intéressant, le traitement thermique est effectué en élevant progressivement la température de la température de dépôt du revêtement sol/gel sur le substrat (typiquement entre 10 et 25°C) à la température de traitement thermique (typiquement au moins 50°C), avec une vitesse d'élévation de la température typiquement comprise entre +0,5°C/minute et +5°C/minute.

Lorsque la couche interne anti-reflet des dispositifs de l'invention est un revêtement transparent déposé par la technique sol/gel précitée, l'alcoxyde minéral qui est utilisé est avantageusement un tétraalcoxysilane, de préférence le tétraméthoxysilane (composé répondant à la formule Si(OCH₃)₄, généralement désigné par son abréviation TMOS, et parfois désigné par tétraméthylorthosilicate) ou bien encore le tétraéthoxysilane (ou TEOS, de formule (Si(OC₂H₅)₄. De façon particulièrement préférée, l'alcoxyde minéral employé est le tétraméthoxysilane TMOS. Alternativement, l'alcoxyde minéral qui est utilisé peut être un alcoxyde de titane (l'isopropoxyde de titanate par exemple) ou bien un alcoxyde de zinc (comme l'isopropoxyde de zinc).

Selon un mode de réalisation particulier, qui se révèle généralement intéressant, le revêtement transparent qui joue le rôle de véhicule des objets dispersés dans la couche interne anti-reflet des dispositifs selon la présente invention peut être un revêtement de type sol/gel particulier, obtenu à partir d'un mélange comprenant initialement (i) au moins un alcoxyde minéral, préférentiellement du type précité ; et (ii) au moins un monomère réticulable sous UV ou sous l'effet d'un traitement thermique (typiquement en présence d'une source de radicaux libres). Dans ce cas, on obtient en général une couche interne anti-reflet ayant une cohésion particulièrement élevée, dans la mesure où la synthèse du revêtement comporte alors un double degré de durcissement, à savoir:
- un premier durcissement est obtenu par hydrolyse et condensation de l'alcoxyde minéral selon la technique sol/gel ; et
- conjointement et/ou en complément, un durcissement supplémentaire s'opère par réticulation du (ou des) monomère(s) réticulable(s), typiquement sous l'effet d'une irradiation UV et/ou d'un chauffage en fonction de la nature exacte des monomères à réticuler.

Les monomères réticulables utilisables selon cette variante spécifique du procédé de l'invention peuvent être des espèces monomères non polymérisées porteuses de fonctions propres à les rendre réticulables sous UV ou thermiquement. Alternativement, il peut s'agir d'espèces macromoléculaires telles que des oligomères ou des polymères porteuses de fonctions propres à les rendre réticulables sous UV ou thermiquement. Les monomères réticulables sous UV ou par voie thermique employés selon ce mode de réalisation sont typiquement des composés porteurs de groupes méthacrylate, acrylate époxy, ou vinyléther. Alternativement, on peut employer des mélanges de deux types de monomères porteurs de fonctions complémentaires qui réagissent l'une sur l'autre lorsqu'elles sont en contact pour conduire à une réticulation par condensation (dans le cadre de cette variante, on peut par exemple employer les couples de fonctions réactives suivants : époxylamine ; acrylate/amine ; isocyanate/alcool ; thiol/ène ; ou époxy/isocyanate.

De façon générale, lorsque le revêtement transparent employé dans la couche interne anti-reflet des dispositifs selon la présente invention est de type sol/gel, il est préférable que ce revêtement sol/gel soit synthétisé en présence d'au moins un tensioactif, en particulier du type décrit dans Sol-Gel Sciences : Sol-Gel : The Physics and Chemistry of Sol Gel Processing, C. Jeffrey Brinker and George W. Scherer, Academic Press (1990) ou dans le Journal of Colloids and Inferface Science, Vol. 274, Issue 2, 355-361. L'emploi de ce type de tensioactif permet de limiter la taille des particules dans le sol obtenu par hydrolyse de l'alcoxyde et permet ainsi un contrôle de l'épaisseur de la couche de revêtement obtenue *in fine.* A titre de tensioactif bien adapté dans ce cadre, on peut notamment citer les tensioactifs polyoxyéthylénés (les esters polyoxyéthylénés en particulier), tels que le TWEEN 85, par exemple.

Un autre moyen permettant de contrôler la taille des particules formée dans le sol réalisé par hydrolyse de l'alcoxyde minéral employé dans la technique sol/gel consiste à employer un mélange d'alcoxydes comprenant des alcoxydes ayant 4 groupes hydrolysables et d'alcoxydes ayant au plus 3 groupes hydrolysables (par exemple deux, voire un seul). Dans ce cadre, le revêtement sol/gel peut typiquement être synthétisé en utilisant, à titre d'alcoxyde minéral, un mélange d'alcoxydes comprenant :
- au moins un silane ayant 4 groupes hydrolysables (comme le tétraméthoxysilane TMOS, ou le tétraéthoxysilane TEOS) ; et
- au moins un silane ayant moins de 4 groupes hydrolysables, ce silane répondant de préférence à la formule RₙSiX₄₋ₙ, dans laquelle :
   - n est un entier égal à 1, 2 ou 3 ;
   - chacun des groupes R, identique ou différent désigne un groupe organique non hydrolysable, éventuellement fonctionnel, et
   - X un groupe hydrolysable (typiquement un groupe alcoxy halogène, par exemple un groupe triméthoxysilane, triéthoxysilane, γ-propyltriméthoxysilane, γ-propyltriéthoxysilane, γ-aminopropyl-triméthoxysilane, γ-aminopropyl-triéthoxysilane, γ-mercaptopropyl-triméthoxysilane, γ-mercaptopropyl-triéthoxysilane, γ-(méth-)acryloylpropryl-triméthoxysilane, γ-(méth-)acryloylpropryl-triéthoxysilane, γ-glycidoxypropyl-triméthoxysilane, γ-glycidoxypropyl-triéthoxysilane, diméthoxysilane, di-éthoxysilane, polydiméthylsiloxane α-ω-disilanol, ou polydiéthylsiloxane α-ω-disilanol ; ou un groupe halogène, tel que - Cl ou Br.

Selon ce mode de réalisation, on peut employer par exemple des silanes porteurs d'un seul groupement hydrolysable, ou des composés précurseurs de tels silanes monofonctionnels, par exemple les composés produisant un silane monofonctionnel suite à une réaction d'hydrolyse, comme, par exemple, le 1,1,1,3,3,3-héxaméthyldisilazane (HMDS) ou encore les chlorosilanes tels que le triméthylchlorosilane.

D'autre part, lorsqu'on met en oeuvre un procédé sol/gel pour réaliser la couche interne anti-reflet des dispositifs selon la présente invention, le milieu de synthèse de ce revêtement comprend de l'eau, éventuellement en association avec un ou plusieurs solvants miscibles à l'eau (par exemple de l'éthanol). L'eau est alors de préférence présente en une quantité équivalente à la moitié des fonctions silanes hydrolysables présentes dans la formulation sol/gel.

Quelle que soit la nature du revêtement transparent qui joue le rôle de véhicule des objets dispersés dans la couche interne anti-reflet des dispositifs selon la présente invention, les objets dispersés que contient cette couche présentent avantageusement les caractéristiques préférentielles de l'une des 3 variantes définies ci-après.

Selon une première variante de l'invention, le coeur des objets présents au sein de la couche interne anti-reflet des dispositifs selon la présente invention est de nature organique.

Dans le cadre de cette première variante de l'invention, le coeur peut par exemple comprendre ou être constitué par :
- au moins un polymère hydrocarboné, linéaire ou (avantageusement) ramifié, dont les chaînes sont éventuellement porteuses d'hétéroatomes ; ou
- au moins un composant ou un mélange de composants ayant une faible masse molaire, typiquement inférieure à 250 g/mol, par exemple des solvants ou des corps huileux.

Dans le cadre de la première variante définie ci-dessus, la couche (écorce) entourant le coeur organique est typiquement une couche de polymère, qui peut typiquement être formée autour du coeur organique par des techniques de polymérisation en émulsion, en dispersion, en mini émulsion ou d'émulsion spontanée. Ces techniques et leur mode de mise en oeuvre sont connus de l'homme du métier. Pour plus de détails les concernant, on pourra par exemple se référer à Soft Matter, vol. 2, pp. 940-949 (2006) ou à Chem Phys Chem. Vol. 6, pp 209-215 (2006).

Les objets à structure coeur/écorce obtenus selon cette première variante de l'invention sont typiquement des capsules (le plus souvent, mais non nécessairement sphéroïdales), qui comprennent une coque polymère, constituant l'écorce, emprisonnant un matériau organique de coeur, de préférence du type précité (polymère distinct du polymère de l'écorce ou composés organiques non polymères, par exemple). Quelle que soit leur structure exacte, ces objets ont typiquement des dimensions entre 50 nm et 2 microns, ces dimensions étant de préférence inférieures à 1 micron, et plus avantageusement inférieures à 800 nm, voire inférieures à 500 nm.

Des objets à structure coeur/écorce selon la première variante de l'invention peuvent par exemple être des capsules comprenant une écorce de polyuréthanes ou de polyamides entourant un coeur d'hexadécane.

D'autres objets à structure coeur/écorce intéressants selon la première variante de l'invention comprennent deux polymères de même type à titre de polymère de coeur et de polymère d'écorce (par exemple deux (méth)acrylates) avec un des polymères porteur de groupements spécifiques non portés par l'autre polymère (des groupes fluor -F, par exemple). Dans ce cas, la structure coeur-écorce étant typiquement obtenue en effectuant la polymérisation des monomères correspondants, en partant initialement d'un milieu de polymérisation contenant uniquement les monomères conduisant à la formation du polymère de coeur (par exemple non porteurs des groupes spécifiques), puis enrichissant le milieu de polymérisation en les monomères conduisant à la formation du polymère de l'écorce (par exemple porteurs des groupes spécifiques). Des objets à structure coeur/écorce utilisables selon le premier mode de réalisation peuvent par exemple être du type des copolymères d'acrylate de butyle et de méthacrylate de trifluoroéthylméthyle décrits dans Macromolecules, vol. 30, 123-129 (1997).

D'autres objets à structure coeur/écorce utilisables selon la première variante de l'invention sont les auto-assemblages de polymères séquencés à structure dibloc comprenant un premier bloc présentant une affinité pour un solvant donné lié à un deuxième bloc présentant une affinité moins forte et de préférence pas d'affinité pour ledit solvant. Lorsque ces polymères sont introduits au sein du solvant, il s'auto-assemblent sous la forme d'objet de type coeur écorce (les blocs présentant une affinité forte pour le solvant formant une couche externe entourant un coeur interne où se regroupent les blocs présentant une affinité moins forte pour le solvant). Des exemples de copolymères séquencés conduisant à ce type d'auto-association en milieu solvant ont en particulier été décrits dans Langmuir, vol. 22, pp. 4534-4540 (2006) (bloc de poly(oxyde d'éthylène)-bloc de (N,N-diéthylaminoéthyl méthacrylate) ou Adv. Funct. Mater., vol. 16, pp. 1506-1514 (2006) (copolymères séquencés diblocs de type (bloc de poly(oxyde d'éthylène))- (bloc de poly(ε-caprolactone)). Les polymères séquencés décrits dans ces documents s'assemblent lorsqu'ils sont placés en milieu solvant pour former des objets comprenant un coeur à base d'un des polymères séquencés et une écorce à base de l'autre polymère séquencé.

Selon une deuxième variante de l'invention, le coeur des objets présents au sein de la couche interne anti-reflet des dispositifs selon la présente invention est de nature inorganique.

Dans le cadre de cette deuxième variante de l'invention, le coeur peut par exemple comprendre ou être constitué par un ou plusieurs des matériaux suivants:
- un oxyde minéral, notamment de la silice ou un oxyde métallique
- un sulfure métallique
- un nitrure métallique
- un halogénure métallique
- un métal.

Plus préférentiellement, le coeur inorganique des objets selon la deuxième variante est constitué de silice, d'oxydes métalliques, de sulfures métalliques et/ou de métaux, plus préférentiellement encore de silice, d'oxydes métalliques (TiO2 ou alumine, notamment) ou de métaux (or, argent, par exemple).

Dans le cadre de cette deuxième variante, selon un premier mode de réalisation, la couche (écorce) entourant le coeur inorganique est une couche de polymère, cette écorce polymère pouvant alors être préparée selon deux grandes voies d'accès, à savoir :

### (1) Les méthodes dites de type "grafting onto"

Selon cette première approche, on part de coeurs inorganiques préexistants (typiquement des particules colloïdales inorganiques) et on immobilise des chaînes polymères préexistantes (ou des greffons préexistants) sur la surface de ces coeurs inorganiques. Pour ce faire, les chaînes polymères ou greffons que l'on souhaite immobiliser sont généralement porteurs de fonctions chimiques aptes à créer une liaison covalente ou électrostatique avec la surface des coeurs inorganiques ou avec un groupement présent sur la surface des coeurs.

Par exemple, on peut partir de particules colloïdales d'or et leur greffer des chaînes polymères porteuses d'une extrémité thiol, par exemple selon la méthode qui a été décrite par exemple dans J. Am. Chem. Soc., vol. 120, 12696 (1998), où des α-méthoxy-ω-mercapto-poly(éthylène glycol) sont greffées sur des particules d'or.

### 2) Les méthodes dites de type "grafting from"

Selon cette deuxième approche, on fait croître des chaînes polymères à partir de particules coeurs fonctionnalisées et porteurs de groupes organiques.

Une méthode largement usité dans ce cadre consiste à initier une polymérisation à partir de coeurs inorganiques (particules colloïdales de préférence) modifiées en surface par des groupes amorçant la polymérisation. Avantageusement les groupes fonctionnels introduits sur la surface des coeurs inorganiques sont des agents de contrôle permettant une réaction de polymérisation radicalaire contrôlée de type ATRP. Par exemple, on peut employer des particules d'or fonctionnalisées par des groupes thio. Des amorceurs de polymérisation bromés peuvent être greffés par la méthode d'échange de ligands, et la polymérisation peut être amorcée en présence de monomères tels que les monomères (méth)-acryliques (méthacrylate de méthyle, méthacrylate d'éthyle, acrylate d'éthyle....) selon la méthode décrite par exemple dans Angew. Chem. Int. Ed., 40, 4016 (2001) ou bien encore dans Macromol. Chem. Phys., 1941-1946 (2005). Les objets obtenus selon la méthode de ce deuxième article (coeur de d'or recouvert par du poly(N-isopropylacrylamide) sont particulièrement bien adapté pour conférer selon l'invention un effet anti-reflet dans le domaine de l'infrarouge sur la surface d'un substrat.

La synthèse d'écorce polymère par ATRP peut également être employée sur des coeurs inorganiques d'oxydes minéraux, en particulier des coeurs inorganiques de silice ou d'oxyde de titane (sous la forme de particules colloïdales notamment), par exemple selon des procédés du type décrit dans Materials Letters, Vol. 62, Issue 8-9, (2008), ou dans Composites Science and Technology, Vol. 66, Issue 9, July 2006.

Il est également possible de greffer des chaînes polymères sur la surface d'objets inorganiques préformés avantageusement porteurs de fonctions -OH et/ou -SH (particules d'or thio-fonctionnalisées par exemple) à partir de réactions de polycondensation (par exemple entre un dithiol et un diester), avantageusement en mettant en contact des objets inorganiques préformés porteurs de fonctions -OH et/ou -SH avec :
- des monomères, comportant des groupements réactifs incluant :
   (i) au moins un groupe incluant un groupement carbonyle α-β insaturé C=C-C=O (par exemple un groupe acrylique, méthacrylique ou acrylamide) et/ou un groupement thiocarbonyle α-β insaturé C=C-C=S ; et/ou
   (ii) au moins un groupe hétérocyclique comprenant de 3 à 5 chaînons (de préférence 3 ou 4 chaînons), choisi parmi les éthers cycliques, les thioéthers cycliques et les cycles aziridiniques, ce groupe hétérocyclique étant de préférence au moins un groupe époxy, thioépoxy ou aziridine, et plus préférentiellement au moins un groupe époxy ou thioépoxy; et/ou
   (iii) au moins un groupe choisi parmi les groupes isocyanate -N=C=O ou thioisocyanate -N=C=S, et les groupements trivalents de formule >C=CZ- , où Z est un groupe électroattracteur (par exemple un groupe 4-nitrophényle, cyano ou -C=N-);
   et
- un catalyseur (C) porteur d'au moins une fonction guanidine conjuguée, de préférence porteur d'une fonction bis-guanidine conjuguée répondant à la formule (I) suivante : 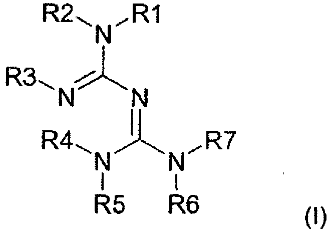 où chacun des groupements R1 à R7 représente, indépendamment des autres groupements :
   - un atome d'hydrogène ; ou
   - un groupe cyano -CN ; ou
   - une chaîne hydrocarbonée, saturée ou insaturée, linéaire ou ramifiée, éventuellement cyclisée en tout ou partie, éventuellement substituée, et éventuellement interrompue par un ou plusieurs hétéroatomes (O, S, N, P, ou Si, par exemple) et/ou par des groupements porteurs d'hétéroatomes tels que des carboxy, amide, ou carbamate (par exemple par des groupes divalents - C(=O)O-, -OC(=O)- , -O-C(=O)-O-, >N-C(=O)- , -C(=O)-N<, >N-C(=O)-O- , -O-C(=O)-N<, -C=N-, -N=C-, cette chaîne étant typiquement :
      - un groupe alkyle, alcényle ou alcynyle, linéaire ou ramifié, comprenant avantageusement de 1 à 12 atomes de carbone, par exemple de 1 à 6 atomes de carbone, ce groupe alkyle, alcényle ou alcynyle étant éventuellement substitué par exemple par un groupe alcoxy ;
      - un groupe cycloalkyle comprenant avantageusement de 6 à 18 atomes de carbone, éventuellement substitué par exemple par au moins un groupe alkyle ou alcoxy ;
      - un groupe aryle comprenant avantageusement de 6 à 18 atomes de carbone, éventuellement substitué, par exemple par au moins un groupe alkyle ou alcoxy ;
      - un hétérocycle, éventuellement aromatique, comprenant un ou plusieurs atomes choisis parmi S, O ou N ;
      - un groupe alkylaryle ou arylalkyle comprenant avantageusement de 8 à 18 atomes de carbone, où la partie aryle est éventuellement substituée, notamment par un groupe alkyle ou alcoxy ;
      - un groupe ester, amide, ou carbamate ; ou
      - une chaîne polymère, éventuellement porteuse d'autres groupements guanidine (de préférence de groupements guanidine conjuguée, le cas échéant).

Le catalyseur employé répond de préférence à la formule ci-dessous :

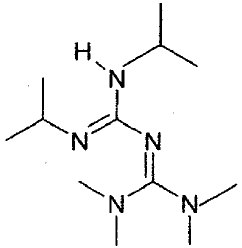

Les coeurs inorganiques à base d'oxyde métallique, de sulfure métallique, de nitrure métallique, d'halogénure métallique ou métalliques peuvent également être recouverts (encapsulés) par une écorce polymère par toute méthode usuelle de synthèse en émulsion ou en dispersion, en particulier selon les méthodes de synthèse radicalaire en émulsion ou en dispersion.

Plus généralement, il est également possible de créer une écorce en émulsion notamment par polymérisation par métathèse par toute autre méthode d'encapsulation adaptée, par exemple selon la méthode décrite dans Soft Matter, vol. 2, pp. 940-949 (2006).

Selon un autre mode de réalisation intéressant de la deuxième variante mettant en oeuvre des coeurs de nature inorganique, la couche (écorce) entourant le coeur inorganique est constituée d'un matériau inorganique distinct de celui présent dans le coeur, ce matériau constituant l'écorce comprenant alors typiquement un oxyde ou un sulfure. Dans ce cas, il est préférable que le coeur soit constitué d'oxyde métallique, de sulfure métallique ou de métal.

Des produits commerciaux possédant un coeur et une écorce de type oxyde métallique sont commercialisés, par exemple par la société Ibu-Tech (Germany), qui propose par exemple des compositions ZnO/SiO₂ dont la taille globale est de 40 nm sous la référence NA403.

A titre d'exemple de particules utilisable selon l'invention, on peut citer les particules à coeur d'or et à écorce de silice obtenues dans l'article publié dans le Journal of Nanoparticle Research, 8, 1083-1087 2008), par une technique d'émulsion inverse impliquant la formation de micelles de NH₄AuCl₄ recouvert d'une couche protectrice de silice obtenue par réduction d'un sel d'or au sein des micelles.

Selon une troisième variante de l'invention, plus spécifique, le coeur des objets présents au sein de la couche interne anti-reflet des dispositifs selon la présente invention est une cavité creuse, typiquement remplie d'air, ayant un indice de réfraction sensiblement égal à 1, cette cavité ayant des dimensions avantageusement inférieure à 1 micron, et de préférence supérieures à 20 nm, par exemple entre 50 et 500 nm.

Selon cette troisième variante, la couche (écorce) entourant le coeur est typiquement constituée par un matériau inorganique. Le plus souvent, les objets présents au sein du revêtement transparent sont typiquement des particules minérales creuses, par exemple des particules creuses de silice ou d'oxyde minéral dites de type "*hollow spheres"* (c'est-à-dire « sphères creuses »), par exemple obtenues par microémulsion ou précipitation de particules colloïdales autour d'agents de texturation (dit *"templates"* en anglais), notamment selon les méthodes décrites dans Materials Chemistry and Physics, Vol 111, Issue 1, (2008) ou Materials Letters Vol. 62, Issue 24, (2008).

Les dispositifs photovoltaïques selon la présente invention peuvent être des cellules photovoltaïques isolées comprenant un coeur semi-conducteur sur lequel est déposé la couche interne antireflet (en contact direct avec le semi-conducteur ou non), puis la couche de protection, telle qu'une plaque de verre ou une feuille polymère, par exemple un feuille de PET ou d'ETFE (en contact direct ou non avec la couche interne anti-reflet). Ces cellules photovoltaïques peuvent être de première génération ou bien de génération ultérieure.

Plus avantageusement, les dispositifs selon l'invention peuvent être des modules photovoltaïques comprenant une association de plusieurs cellules photovoltaïques comprenant un coeur semi-conducteur sur lequel est déposée la couche interne antireflet (en contact direct avec le semi-conducteur ou non), généralement juxtaposées, mises en contact électrique les unes avec les autres et enrobées par une matrice polymère, par exemple une matrice d'EVA (copolymère éthylène-acétate de vinyle), cette association de cellules photovoltaïques étant revêtue par une couche de protection, telle qu'une plaque de verre. Les cellules photovoltaïques enrobées dans la matrice polymère peuvent par exemple être placées entre deux plaques de verre (procédé bi-verre) ou entre une plaque de verre et un ensemble constitué de couches minces de polymères (tedlar, mylar) et d'aluminium (procédé mono-verre).

Différents aspects et avantages de l'invention ressortiront encore de l'exemple ci-après, où on a réalisé un dispositif photovoltaïque de type module photovoltaïque à base de 4 cellules photovoltaïques recouvertes par une couche anti-reflet comprenant, à titre d'objets dispersés, des particules hybrides silice-polyester, qui ont un coeur de silice de diamètre égale à 80 nm, recouvert par une écorce de polymère de 200 nm, particules hybrides désignées ci-après par "matériau hybride HR1".

### Exemple 1

### ▪ Synthèse du matériau hybride HR1

Sous agitation vigoureuse, on a formé une dispersion aqueuse à 20% en masse de particules de silice de taille égale à 15 nm (Sigma Aldrich).

En maintenant l'agitation, on a introduit dans la dispersion ainsi réalisée à 40°C un silane (tétraméthoxysilane TMOS) à raison de 50% en masse par rapport à la masse de la silice présente dans le milieu réactionnel, en présence d'un catalyseur basique (ammoniaque), puis 0,6 équivalents molaire (par rapport à la quantité de TMOS introduite) d'un précurseur dihydroxylé dissous dans de l'éthanol (destiné à améliorer « l'accroche » de la couche polymère sur les coeur de silice).

Le précurseur dihydroxylé employé a été préparé en effectuant un mélange équimolaire d'isocyanatopropyltriéthoxysilane et de diéthanolamine, en présence de dilaurate de dibutyl-étain, à une température de 50°C. On a ensuite ajouté à ce milieu réactionnel du triméthylolpropane (TMP) et du diméthylsuccinate (DMS), chacun à raison 8 équivalents molaires par rapport au TMOS.

On a laissé le milieu évoluer pendant quelques minutes, puis on a évaporé sous vide les solvants présents (eau et éthanol), à 95°C. On ainsi obtenu des particules de silice de taille sensiblement égale à 80 nm.

On a ensuite introduit dans le milieu, à 40°C et sous vide poussé (-1 bar), un catalyseur bisguanidine répondant à la formule suivante :

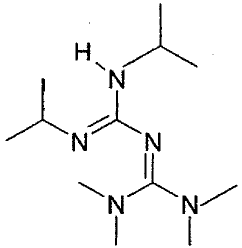

L'introduction de ce catalyseur a induit une polycondensation du TMP et du DMS présents dans le milieu réactionnel, ce par quoi on a créé une écorce polymère (de type polyester) autour des particules de silice.

La structure de type coeur écorce ainsi obtenue a ensuite été modifiée pour la rendre dispersible (dans l'eau ou les monomères). A cet effet, on a conduit une fonctionnalisation de la surface des objets obtenus par des fonctions méthacrylates, en ajoutant aux particules obtenues du méthacrylate de méthyle, à raison de 1,2 équivalent molaire par rapport au TMP (à 40°C et sous vide de -1 bar).

A l'issue de ces différents traitements, on a obtenu le matériau hybride HR1, sous la forme d'une poudre comprenant des particules hybrides silice-polyester, ayant un coeur de silice de diamètre égale à 80 nm, recouvert par une écorce de polymère de 200 nm.

### Synthèse des cellules photovoltaïques

Chacune des cellules photovoltaïques a été préparée comme suit. :

### dépôt d'une couche de SiN et métallisation

Une tranche (wafer) de silicium monocristallin de dimensions égales à 125 mm x 125 mm et d'épaisseur égale à 200 microns a été découpée dans un monocristal, plongée dans un bain de potasse à 80°C (pour supprimer les défauts de surface), puis rincée dans un bain d'eau distillée. On a ensuite réalisé un dopage du silicium par diffusion de phosphore en plaçant la tranche dans un four porté à 850°C en présence de POCl₃ et d'oxygène. A la suite de ce traitement, la tranche a été plongée dans un bain d'acide fluorhydrique.

Une couche de SiN a ensuite été déposée sur la tranche ainsi préparée, selon un procédé de PECVD direct, à une fréquence de 40 kHz, à 450°C, en présence de NH₃ et SiH₄, ce par quoi on a formé une couche de SiN de 80 nm d'épaisseur et ayant un indice de réfraction de 2,05.

Une métallisation de surface a été réalisée en formant par sérigraphie des pistes métalliques sur la couche de SiN (contacts avants) et sur la face du silicium non recouverte par le SiN (contacts arrières). Ces pistes métalliques ont été formées en déposant une pâte d'argent, puis en la portant à 850°C.

### dépôt d'une couche antireflet selon l'invention comprenant le matériau hybride HR1

Une couche anti-reflet selon l'invention a ensuite été déposée sur la couche de SiN selon un procédé sol-gel en mettant en oeuvre le protocole ci-après.

Dans un ballon, à température ambiante (25°C), on a mélangé 0,340 g d'eau distillée, 6,053 g d'éthanol et 30 mg d'acide chlorhydrique (37%), commercialisé par Sigma Aldrich sous la référence 310331, puis on a ajouté un mélange de 1,446g de TMOS (tétraméthylorthosilicate de pureté égale à 99% commercialisé par Sigma Aldrich sous la référence 218472) et 0,076 g de MPTS (3-(méthacryloxy)propyltriméthoxysilane, de pureté égale à 97% commercialisé par ABCR sous la référence AB117674).

Le ballon a été obturé et on a laissé le mélange réagir à température ambiante (25°C) et sous agitation pendant 4h.

On a ensuite ajouté au milieu réactionnel une solution contenant 0,152g du matériau hybride silice-polyester HR1 précité, dissous dans un mélange de 0,038 g d'eau distillée et 0,673g d'éthanol absolu.

Le milieu ainsi obtenu a été laissé sous agitation à température ambiante (25°C) pendant 1 h, puis conservé à température ambiante pendant 20h.

Le dépôt de cette composition sur la cellule de silicium recouverte de SiN a été réalisé selon la technique de trempage retrait (dip-coating). Pour ce faire, la cellule de silicium recouverte de SiN a été préalablement nettoyée à l'éthanol et protégée au niveau de ses pistes électriques par un adhésif pelable (adhésif F/LB, ATP Adhesive Systems).

Le dépôt de la couche anti-reflet a été effectué en immergeant totalement la cellule dans la composition, puis en la retirant progressivement hors de la composition à une vitesse linéaire de 2 mm/s, ce par quoi on a obtenu un revêtement continu, homogène et transparent sur la surface de la couche de SIN précédemment déposée.

La cellule munie du dépôt ainsi réalisé a ensuite été placée dans une étuve pendant 2 heures à 120°C.

On a ainsi obtenu le dépôt, sur la surface de la cellule, d'une couche revêtement ayant une épaisseur de l'ordre de 350 nm.

### Synthèse du module photovoltaïque

Les 4 cellules photovoltaïques, sensiblement identiques, réalisés dans les conditions décrites ci-dessus ont été employées pour synthétiser un module photovoltaïque.

Pour ce faire, après retrait de l'adhésif pelable recouvrant les contacts électriques, les cellules ont été déposées côte à côte (en guirlande) sur une feuille d'aluminium et connectées entre elles électriquement. Une feuille d'EVA (feuille d'épaisseur égale à 0,5 mm commercialisée par la société Whenzhou Longwan Plastic Additives Co., Ltd.) a été déposée sur le système ainsi formé, puis une feuille de verre a été déposée sur l'ensemble.

La structure multicouche de l'ensemble ainsi formé a été laminée au sein d'un laminateur comprenant une cavité séparée par une membrane déformable en deux parties à savoir (i) une partie basse comportant à titre de plan de base une résistance chauffante ; et (ii) une chambre supérieure. Pour ce faire, l'ensemble formé par les quatre cellules déposées sur la feuille d'aluminium et recouverte par la feuille d'EVA et la feuille de verre a été introduit dans la chambre inférieure, sur la résistance chauffante portée à une température de 100°C et à pression atmosphérique, avec une dépression (0.1 mmHg) créée dans la chambre supérieure au moment de l'introduction de l'ensemble. Ensuite, la chambre inférieure a été mise en dépression (0,1 mmHg) pendant 5 minutes, la membrane déformable venant se plaquer sur la feuille de verre et écrasant de ce fait la feuille de polymère portée à 100°C. Après remise sous pression atmosphérique de la chambre inférieure du laminateur, le module réalisé a été retiré du laminateur et porté à 156°C dans un four pendant 15 minutes de façon à réaliser sa réticulation.

A des fins de comparaison, un module témoin a été réalisé dans exactement les mêmes conditions que le module décrit ci-dessus, avec comme unique différence que l'on a pas déposé de couche anti-reflet selon l'invention, à base du matériau hybride HR1.

Le module selon l'invention présente des propriétés nettement améliorées en comparaison du module témoin.

### Exemple 2 : Application du revêtement antireflet avant la métallisation de surface des cellules photovoltaïques

Les cellules photovoltaiques sont préparées de la même façon que selon la description de l'exemple 1. Une tranche (wafer) de silicium monocristallin de dimensions égales à 125 mm x 125 mm et d'épaisseur égale à 200 microns a été découpée dans un monocristal, plongée dans un bain de potasse à 80°C (pour supprimer les défauts de surface), puis rincée dans un bain d'eau distillée. On a ensuite réalisé un dopage du silicium par diffusion de phosphore en plaçant la tranche dans un four porté à 850°C en présence de POCl₃ et d'oxygène. A la suite de ce traitement, la tranche a été plongée dans un bain d'acide fluorhydrique.

Une couche de SiN a ensuite été déposée sur la tranche ainsi préparée, selon un procédé de PECVD direct, à une fréquence de 40 kHz, à 450°C, en présence de NH₃ et SiH₄. ce par quoi on a formé une couche de SiN de 80 nm d'épaisseur et ayant un indice de réfraction de 2,05.

Une couche antireflet selon l'invention a ensuite été déposée sur la couche de SiN selon un procédé sol-gel mettant en oeuvre le protocole ci-après.

Dans un ballon à température ambiante, on a mélangé 70g d'éthanol avec 10g d'une solution colloïdale d'oxyde de silicium SiO₂. Cette solution est une dispersion aqueuse à 40% en poids de particules de SiO₂ de taille 20 nm, commercialisée par Alfa Aesar. Puis on a ajouté un mélange de 72,857g d'éthanol et de 17,143g du vernis sol-gel décrit dans l'exemple 1. Ce mélange a été agité pendant 3h, à température ambiante (25°C). On a ensuite ajouté au milieu réactionnel 90g de butanol, et agité le tout 1 h.

Le dépôt de cette composition sur la cellule de silicium recouverte de SiN a été réalisé selon la technique de trempage retrait (dip-coating). Pour ce faire, la cellule de silicium recouverte de SiN est préalablement nettoyée à l'éthanol et protégée au niveau de sa face arrière par un adhésif pelable (adhésif F/LB, ATP Adhesive Systems). Le dépôt de la couche antireflet a été effectué en immergeant totalement la cellule dans la composition, puis en la retirant progressivement hors de la composition à une vitesse linéaire de 2 mm/s, ce par quoi on a obtenu un revêtement continu, homogène et transparent sur la surface de la couche de SIN précédemment déposée.

La cellule munie du dépôt ainsi réalisé a ensuite été placée dans une étuve pendant 1 heure à 120°C.

On a ainsi obtenu le dépôt, sur la surface de la cellule, d'une couche de revêtement ayant une épaisseur de l'ordre de 150 nm.

Une métallisation de surface a été ensuite réalisée en formant par sérigraphie des pistes métalliques sur la couche de SiN (contacts avants) et sur la face du silicium non recouverte par le SiN (contacts arrières). Ces pistes métalliques ont été formées en déposant une pâte d'argent, puis en portant celle-ci à 850°C.

La synthèse du module photovoltaïque est finalisée comme décrit dans l'exemple 1, et le module selon l'invention présente des propriétés électriques améliorées en comparaison du module témoin.

### Exemple 3 : La couche antireflet de l'invention peut également être déposée sur la feuille de verre déposée à la surface des modules photovoltaïques.

On dépose par dip coating, à une vitesse de 1,4mm/s, un mélange du vernis sol-gel cité à l'exemple 2 et de solvant éthanol (à 10g du vernis décrit à l'exemple 2 ont été ajoutés 16g d'éthanol). La couche antireflet, issue de la présente invention est ensuite séchée pendant 2 heures à 120°C.

La feuille de verre ainsi vernie est ensuite déposée sur un module photovoltaïque, réalisé selon la description de l'exemple 1. Ce module présente des propriétés nettement améliorées en comparaison du module témoin.

### Exemple 4 : couche antireflet sur un module photovoltaïques flexible.

La couche antireflet de la présente invention a été utilisée sur un module solaire flexible. Sur un film de PET (polyéthylène téréphtalate) souple, un vernis dur de type polysiloxane est déposé par dip coating à 2,5mm/s, une des faces du film étant protégée. Ce vernis dur est fourni par la société Gaematech, sous la gamme Mexmer. Ce vernis dur est séché pendant 1 h à 120°C, dans une étuve à convection forcée.

La couche antireflet de la présente invention, décrite dans l'exemple 3 (vernis sol-gel de l'exemple 1 dilué dans de l'éthanol), est ensuite déposée par dip coating à une vitesse de 1,8mm/s, et séchée 1 h à 120°C.

Ce film de PET verni est ensuite déposé sur un module solaire flexible classique, la face vernie par l'assemblage antireflet étant placée contre le module. Le contact entre le module et le film de PET traité est réalisé par une fine couche d'isopropanol, qui en séchant permet un contact entre le PET traité et le module photovoltaïque. A des fins de comparaison, un module témoin est réalisé dans les mêmes conditions que le module décrit ci-dessus, avec comme unique différence que le film de PET n'a pas été verni par la couche antireflet (sol-gel).

Le module flexible selon l'invention présente des propriétés électriques améliorées en comparaison du module témoin.

### Exemple 5 : couche antireflet sur la lentille d'un système solaire à concentration (CPV)

On a réalisé le montage de systèmes photovoltaïques à concentration (CPV). Ces systèmes sont composés de deux parties :
- La première est une lentille plan-convexe en verre soda-calcique qui assure un facteur de concentration de 500x
- La seconde partie est composée d'un assemblage à triple jonction fourni par Spectrolab, placée dans le plan focal de la lentille

Une lentille a ainsi été traitée antireflet en appliquant le vernis sol gel décrit à l'exemple 2. On a traité la lentille sur ses deux faces par dip-coating selon la séquence suivante :
1) Nettoyage :
   - Trempage dans un bain de lessive acide équipé de générateurs d'ultrasons
   - Rinçage dans 2 bains successifs d'eau de ville, puis d'eau déminéralisé
   - Séchage pendant 3 minutes dans un bain d'air chaud pulsé.
2) Vernissage par dip-coating :
   La lentille est trempée dans un bain contenant le vernis sol-gel décrit à l'exemple 2 et maintenu à 20°C bain, puis retirée à une vitesse constante de 2mm/s. Après 5 minutes à température ambiante elle est cuite à 120°c pendant 1 heure.

On a ensuite réalisé un module CPV témoin à partir d'une lentille non traitée et un module CPV test à partir d'une lentille traitée.

Ces deux modules ont ensuite été placés en extérieur par temps ensoleillé et éclairés en conditions d'ensoleillement direct. Les performances électriques et optiques des deux modules ont été mesurées. Les résultats sont consignés dans le tableau ci après :

| | Mesures | |
|---|---|---|
| | Puissance lumineuse (en %) | Puissance électrique (en %) |
| Lentille non traités | 80.45 | 79.73 |
| Lentille traitée | 84.37 | 83.80 |

## Revendications

1. Dispositif photovoltaïque qui comprend :
- un matériau semi-conducteur propre à assurer un effet photovoltaïque lorsqu'il est soumis à un rayonnement électromagnétique ;
- une couche antireflet, transparente vis-à-vis dudit rayonnement électromagnétique assurant l'effet photovoltaïque, cette couche antireflet contenant, à l'état dispersé, des objets de dimensions inférieures à 5 microns, de préférence inférieures à 2 microns, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n_{C}; et
- une couche entourant le coeur, dite écorce, ayant un deuxième indice de réfraction n_{E}, distinct de l'indice de réfraction n_{C} du coeur, le rapport des dimensions du coeur aux dimensions de l'ensemble coeur/écorce étant compris entre 1 :1,5 et 1 :5.

2. Dispositif photovoltaïque selon la revendication 1, qui comprend :
- un matériau semi-conducteur propre à assurer un effet photovoltaïque ;
- une couche protectrice dudit matériau semi-conducteur ; et
- entre le matériau semi conducteur et la couche protectrice, une couche interne anti-reflet, transparente vis-à-vis dudit rayonnement électromagnétique assurant l'effet photovoltaïque, cette couche interne antireflet contenant, à l'état dispersé, des objets de dimensions inférieures à 5 microns, de préférence inférieures à 2 microns, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n_{C}; et
- une couche entourant le coeur, dite écorce, ayant un deuxième indice de réfraction n_{E}, distinct de l'indice de réfraction n_{C} du coeur, le rapport des dimensions du coeur aux dimensions de l'ensemble coeur/écorce étant compris entre 1 :1,5 et 1 :5.

3. Dispositif photovoltaïque selon la revendication 1, comprenant un système solaire à concentration équipé d'une lentille, où la couche antireflet est appliquée sur une face ou sur les deux faces de la lentille, en contact direct ou indirect avec la surface correspondante de la lentille.

4. Dispositif photovoltaïque selon l'une des revendications 1 à 3, où les objets présents à l'état dispersé au sein de la couche interne anti-reflet ont des dimensions inférieures à 1 micron, de préférence inférieures à 500 nm.

5. Dispositif photovoltaïque selon la revendication 2 ou la revendication 2 ensemble la revendication 4, où la couche protectrice est une feuille de verre ou une feuille polymère de préférence à base de PET ou de ETFE.

6. Dispositif photovoltaïque selon l'une des revendications 2 et 5, ou la revendication 2 ensemble la revendication 4, où la couche protectrice est déposée sur une sous-couche polymère, telle qu'une matrice d'EVA, et où la couche interne anti-reflet est entre le matériau semi-conducteur la sous-couche de polymère.

7. Dispositif photovoltaïque selon l'une des revendications 1 à 6, où la couche anti-reflet a une épaisseur comprise entre 10 nm et 1 microns.

8. Dispositif photovoltaïques selon l'une des revendications 1 à 6, où la couche anti-reflet a une épaisseur comprise entre 50 nm et 500 nm.

9. Dispositif photovoltaïque selon l'une des revendications 2 et 5, ou la revendication 2 ensemble la revendication 4" où la couche protectrice est en outre pourvue d'un revêtement antireflet.

10. Dispositif photovoltaïque selon la revendication 9, où le revêtement anti-reflet déposé sur la couche protectrice est un revêtement transparent, monocouche ou multicouche, contenant, à l'état dispersé, des objets des objets de dimensions inférieures à 5 microns, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n'_{C; et}
- une couche entourant le coeur, dite écorce, ayant un deuxième indice de réfraction n'_{E} , distinct de l'indice de réfraction n'_{C} du coeur, où le rapport des dimensions du coeur aux dimensions de l'ensemble coeur/écorce est compris entre 1 :1,5 et 1 :5.

11. Dispositif photovoltaïque selon l'une des revendications 1 à 10, où le dispositif est un module photovoltaïque.

12. Utilisation d'un matériau transparent vis-à-vis du rayonnement électromagnétique, contenant, à l'état dispersé, des objets de dimensions inférieures à 5 microns, de préférence inférieures à 2 microns, lesdits objets comprenant au moins deux zones constituées de deux substrats différents, transparents vis-à-vis dudit rayonnement électromagnétique et ayant des indices de réfraction distincts, à savoir :
- un coeur ayant un premier indice de réfraction n_{C}; et
- une couche entourant le coeur, dite écorce, ayant un deuxième indice de réfraction n_{E}. distinct de l'indice de réfraction n_{C} du coeur, le rapport des dimensions du coeur aux dimensions de l'ensemble coeur/écorce étant compris entre 1 :1,5 et 1 :5,
pour former une couche antireflet pour un dispositif photovoltaïque, cette couche étant transparente vis-à-vis du rayonnement électromagnétique assurant l'effet photovoltaïque.

## Patentansprüche

1. Photovoltaische Vorrichtung, die umfasst.
- ein Halbleitermaterial, das imstande ist, eine Photovoltaikwirkung sicherzustellen, wenn es einer elektromagnetischen Strahlung ausgesetzt wird,
- eine gegenüber der elektromagnetischen Strahlung, die die Photovoltaikwirkung sicherstellt, transparente Antireflexschicht, wobei diese Antireflexschicht in dispergiertem Zustand Objekte mit Abmessungen von weniger als 5 Mikron, vorzugsweise von weniger als 2 Mikron, enthält, wobei die Objekte mindestens zwei Zonen umfassen, die von zwei verschiedenen Substraten gebildet sind, die gegenüber der elektromagnetischen Strahlung transparent sind und unterschiedliche Refraktionsindexe haben, nämlich:
- einen Kern mit einem ersten Refraktionsindex n_{c} und
- eine den Kern umhüllende, als Rinde bezeichnete Schicht mit einem zweiten Refraktionsindex n_{E}, der sich vom Refraktionsindex n_{c} des Kerns unterscheidet, wobei das Verhältnis der Abmessungen des Kerns zu den Abmessungen der Einheit Kern/Rinde zwischen 1:1,5 und 1:5 inklusive ist.

2. Photovoltaische Vorrichtung nach Anspruch 1, die umfasst:
- ein Halbleitermaterial, das imstande ist, eine Fotovoltaikwirkung sicherzustellen,
- eine Schutzschicht des Halbleitermaterials und
- zwischen dem Halbleitermaterial und der Schutzschicht eine gegenüber der elektromagnetischen Strahlung, die die Photovoltaikwirkung sicherstellt, transparente interne Antireflexschicht, wobei diese interne Antireflexschicht in dispergiertem Zustand Objekte mit Abmessungen von weniger als 5 Mikron, vorzugsweise von weniger als 2 Mikron, enthält, wobei die Objekte mindestens zwei Zonen umfassen, die von zwei verschiedenen Substraten gebildet sind, die gegenüber der elektromagnetischen Strahlung transparent sind und unterschiedliche Refraktionsindexe haben, nämlich:
- einen Kern mit einem ersten Refraktionsindex n_{c} und
- eine den Kern umhüllende, als Rinde bezeichnete Schicht mit einem zweiten Refraktionsindex n_{E}, der sich vom Refraktionsindex n_{c} des Kerns unterscheidet, wobei das Verhältnis der Abmessungen des Kerns zu den Abmessungen der Einheit Kern/Rinde zwischen 1:1,5 und 1:5 inklusive ist.

3. Photovoltaische Vorrichtung nach Anspruch 1, die ein konzentriertes, mit einer Linse ausgestattetes Solarsystem umfasst, wobei die Antireflexschicht auf eine Seite oder auf die zwei Seiten der Linse in direktem oder indirektem Kontakt mit der entsprechenden Fläche der Linse aufgetragen ist.

4. Photovoltaische Vorrichtung nach einem der Ansprüche 1 bis 3, wobei die im dispergierten Zustand innerhalb der internen Antireflexschicht vorhandenen Objekte Abmessungen von weniger als 1 Mikron, vorzugsweise von weniger als 500 nm, haben

5. Photovoltaische Vorrichtung nach Anspruch 2 oder nach Anspruch 2 gemeinsam mit Anspruch 4, wobei die Schutzschicht eine Glasfolie oder eine Polymerfolie vorzugsweise auf der Basis von PET oder von ETFE ist.

6. Photovoltaische Vorrichtung nach einem der Ansprüche 2 und 5 oder nach Anspruch 2 gemeinsam mit Anspruch 4, wobei die Schutzschicht auf eine Polymerunterschicht wie eine EVA-Matrix aufgebracht ist, und wobei die interne Antireflexschicht zwischen dem Halbleitermaterial und der Polymerunterschicht ist.

7. Photovoltaische Vorrichtung nach einem der Ansprüche 1 bis 6, wobei die Antireflexschicht eine Dicke zwischen 10 nm und 1 Mikron inklusive hat.

8. Photovoltaische Vorrichtung nach einem der Ansprüche 1 bis 6, wobei die Antireflexschicht eine Dicke zwischen 50 nm und 500 nm inklusive hat.

9. Photovoltaische Vorrichtung nach einem der Ansprüche 2 und 5 oder nach Anspruch 2 gemeinsam mit Anspruch 4, wobei die Schutzschicht ferner mit einer Antireflexbeschichtung versehen ist.

10. Photovoltaische Vorrichtung nach Anspruch 9, wobei die auf der Schutzschicht aufgebrachte Antireflexbeschichtung eine transparente, einschichtige oder mehrschichtige Beschichtung ist, die im dispergierten Zustand Objekte mit Abmessungen von weniger als 5 Mikron enthält, wobei die Objekte mindestens zwei Zonen umfassen, die von zwei verschiedenen Substraten gebildet sind, die gegenüber der elektromagnetischen Strahlung transparent sind und unterschiedliche Refraktionsindexe haben, nämlich:
- einen Kern mit einem ersten Refraktionsindex n'_{c} und
- eine den Kern umhüllende, als Rinde bezeichnete Schicht mit einem zweiten Refraktionsindex n'_{E}, der sich vom Refraktionsindex n'_{c} des Kerns unterscheidet, wobei das Verhältnis der Abmessungen des Kerns zu den Abmessungen der Einheit Kern/Rinde zwischen 1:1,5 und 1:5 inklusive ist.

11. Photovoltaische Vorrichtung nach einem der Ansprüche 1 bis 10, wobei die Vorrichtung ein Photovoltaikmodul ist.

12. Verwendung eines gegenüber elektromagnetischer Strahlung transparenten Materials, das in dispergiertem Zustand Objekte mit Abmessungen von weniger als 5 Mikron, vorzugsweise von weniger als 2 Mikron, enthält, wobei die Objekte mindestens zwei Zonen umfassen, die von zwei verschiedenen Substraten gebildet sind, die gegenüber der elektromagnetischen Strahlung transparent sind und unterschiedliche Refraktionsindexe haben, nämlich:
- einen Kern mit einem ersten Refraktionsindex n_{c} und
- eine den Kern umhüllende, als Rinde bezeichnete Schicht mit einem zweiten Refraktionsindex n_{E}, der sich vom Refraktionsindex n_{c} des Kerns unterscheidet, wobei das Verhältnis der Abmessungen des Kerns zu den Abmessungen der Einheit Kern/Rinde zwischen 1:1,5 und 1:5 inklusive ist,
um eine Antireflexschicht für eine photovoltaische Vorrichtung zu bilden, wobei diese Schicht gegenüber der elektromagnetischen Strahlung, die die Photovoltaikwirkung sicherstellt, transparent ist.

## Claims

1. A photovoltaic device which comprises:
- a semiconducting material able to ensure a photovoltaic effect when it is subject to electromagnetic radiation;
- an anti-reflective layer, transparent towards said electromagnetic radiation ensuring the photovoltaic effect, this anti-reflective layer containing, in the dispersed state, objects with dimensions of less than 5 microns, preferably less than 2 microns, said objects comprising at least two areas consisting of two different substrates, transparent towards said electromagnetic radiation and having distinct refraction indices, i.e.:
- a core having a first refractive index n_{C}; and
- a layer surrounding the core, a so-called crust, having a second refractive index n_{E}, distinct from the refractive index n_{C} of the core, the ratio of the dimensions of the core to the dimensions of the core/crust assembly being comprised between 1:1.5 and 1:5.

2. The photovoltaic device according to claim 1, which comprises:
- a semiconducting material able to ensure a photovoltaic effect;
- a protective layer of said semiconducting material; and
- between the semiconducting material and the protective layer, an anti-reflective internal layer, transparent towards said electromagnetic radiation ensuring the photovoltaic effect, this anti-reflective internal layer containing, in the dispersed state, objects with dimensions of less than 5 microns, preferably less than 2 microns, said objects comprising at least two areas consisting of two different substrates transparent towards said electromagnetic radiation and having distinct refractive indices, i.e.:
- a core having a first refractive index n_{C}; and
- a layer surrounding the core, a so-called crust, having a second refractive index n_{E}, distinct from the refractive index n_{C} of the core, the ratio of the dimensions of the core to the dimensions of the core/crust assembly comprised between 1:1.5 and 1:5.

3. The photovoltaic device according to claim 1, comprising a solar concentration system equipped with a lens, wherein the anti-reflective layer is applied on one face or on both faces of the lens, in either direct or indirect contact with the corresponding surface of the lens.

4. The photovoltaic device according to one of the claims 1 to 3, wherein the objects present in the dispersed state within the anti-reflective internal layer have dimensions of less than 1 micron, preferably less than 500 nm.

5. The photovoltaic device according to claim 2 or claim 2 together with claim 4, wherein the protective layer is a glass sheet or a polymeric sheet preferably based on PET or ETFE.

6. The photovoltaic device according to one of claims 2 and 5 or claim 2 together with claim 4, wherein the protective layer is deposited on a polymeric sublayer, such as an EVA matrix, and wherein the anti-reflective internal layer is between the semiconducting material and the polymer sublayer.

7. The photovoltaic device according to one of claims 1 to 6, wherein the anti-reflective layer has a thickness comprised between 10 nm and 1 micron.

8. The photovoltaic device according to one of claims 1 to 6, wherein the anti-reflective layer has a thickness comprised between 50 nm and 500 nm.

9. The photovoltaic device according to one of claims 2 and 5, or claim 2 together with claim 4, wherein the protective layer is further provided with an anti-reflective coating.

10. The photovoltaic device according to claim 9, wherein the anti-reflective coating deposited on the protective layer is a transparent, single-layer or multilayer, coating, containing in the dispersed state, objects with dimensions of less than 5 microns, said objects comprising at least two areas consisting of two different substrates, transparent towards said electromagnetic radiation and having distinct refractive indices, i.e.:
- a core having a first refractive index n'_{C}; and
- a layer surrounding the core, a so-called crust, having a second refractive index n'_{E} distinct from the refractive index n'_{C} of the core, wherein the ratio of the dimensions of the core to the dimensions of the core/crust assembly is comprised between 1:1.5 and 1:5.

11. The photovoltaic device according to one of claims 1 to 10, wherein the device is a photovoltaic module.

12. The use of a material transparent towards the electromagnetic radiation, containing, in the dispersed state, objects with dimensions of less than 5 microns, preferably less than 2 microns, said objects comprising at least two areas consisting of two different substrates, transparent towards said electromagnetic radiation and having distinct refractive indices, i.e.:
- a core having a first refractive index n_{C}; and
- a layer surrounding the core, a so-called crust, having a second refractive index n_{E}, distinct from the refractive index n_{C} of the core, the ratio of the dimensions of the core to the dimensions of the core/crust assembly being comprised between 1:1.5 and 1:5,
in order to form an anti-reflective layer for a photovoltaic device, this layer being transparent towards the electromagnetic radiation ensuring the photovoltaic effect.
